# EUROPEAN PATENT SPECIFICATION

(11) **EP 0 702 272 B1**
(45) Date of publication and mention of the grant of the patent: **07.08.2002**
(21) Application number: 95306182.7
(22) Date of filing: 05.09.1995
(51) Int. Cl.: G03F 9/00, G03F 7/22

(54) **Exposure apparatus and exposure method**
Belichtungsapparat und Belichtungsverfahren
Appareil d'exposition et méthode d'exposition

(30) Priority: 05.09.1994 JP 23447994
(43) Date of publication of application: 20.03.1996
(60) Divisional application: 02075268.9
(73) Proprietor: CANON KABUSHIKI KAISHA, Tokyo (JP)
(72) Inventor: Sakai, Fumio, Ohta-ku, Tokyo (JP)
(74) Representative: Beresford, Keith Denis Lewis

(56) References cited:
- EP-A- 0 150 129
- US-A- 4 780 617

## Description

This invention relates to an exposure apparatus (called "stepper") and an exposure method, capable of performing very high precision exposure ; and a method of producing an integrated circuit.

A wafer to be exposed by a stepper has a layout of shots (shot areas) thereon with respect to each of which the alignment of the wafer is to be done through the step-and-repeat motion. This layout is determined in accordance with the exposure size, to be exposed in that stepper. For example, if the exposure size is 20 mm square, the wafer is formed with a layout of 20 mm pitch, only. Many operations such as alignment operation, focus leveling adjustment or exposure operation are done on the basis of this layout.

However, with recent enlargement of the exposure size of steppers, the number of step-and-repeat motions (usually corresponding to the number of shots) to be done to a wafer has been decreased. If the alignment operation or focus leveling adjustment is made in the layout with a decreased number of shots, problems such as follows arise.

Firstly, currently, the alignment procedure uses an alignment method called global alignment, taking both the productivity of IC or LSI and the alignment precision into account. In this method, from measured values taken on a few shots (sample shots) of a wafer, positional information about the shot layout of the wafer is detected and, based on this, alignment operations for all the shots of the wafer are executed. However, if the number of shots on a wafer is reduced, the selection of sample shots is restricted, resulting in a decrease of alignment precision.

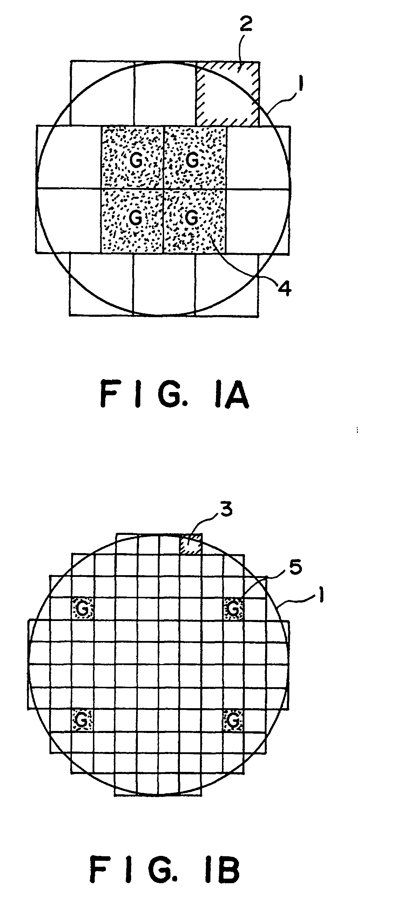

For example, in-a case of an 8-inch (1"=2.54 cm) diameter wafer having a layout with an exposure size of 50 mm square (Figure 1A), only about fourteen shots 2 can be defined on the wafer 1. In this example, taking into account the possibility that, at the wafer periphery, the measured values to be used for the alignment may contain errors due to distortion of the wafer or to variation in film thickness of photosensitive material on the wafer 1, the only possible course is to select four sample shots 4 about the centre of the wafer 1. If the global alignment method is to be carried out on the basis of only the four sample shots about the centre of the wafer 1, the span of the sample shots to be measured in the vicinity of the center of the wafer 1 is very short and the number of sample shots is very small (only 4), the precision of measurement to rotation or magnification of the shot layout within the wafer 1 will be degraded. Setting a larger interval (span) between sample shots and using a larger number of sample shots, effectively reduces errors in the measured value.

Secondly, as for focus leveling adjustment, there are two methods: a global leveling method wherein leveling of a wafer 1 as a whole is performed on the basis of a few sample shots but the focusing is adjusted for every shot; and a die-by-die leveling method wherein both the leveling and the focusing are adjusted for every shot. In the leveling operation according to the global leveling method, shortness in the span of sample shots and smallness in the number of sample shots causes degradation of a measured value, like in the alignment operation. In the die-by-die leveling method, there is a choice that, when peripheral shots of a wafer 1 include one with respect to which the measurement for focus leveling is not attainable, the focus leveling of that shot is performed by using the information of the focus leveling value related to the preceding shot. In this case, however, if the layout has only a small number of shots, the "preceding" shot is remote. Thus, there occurs a large error in the prediction of the "current" shot.

An exposure apparatus as set forth in the preamble of claim 1 attached is known from e.g. US-A-4780617. As therein disclosed, layout data, used for measurement of alignment marks of sample shots, is corrected, and the corrected data is then used as layout data for the subsequent sequence of shot exposures.

It is an object of the present invention to provide an exposure apparatus and an exposure method which enables correct global alignment regardless of large exposure frame size.

The exposure apparatus of the present invention is characterised in that: the control means is adapted to control the following operations of an exposure sequence for performing the exposure of a plurality of shot areas of the size which is in accordance with the second exposure frame size:
positioning of the substrate for detection of the alignment mark of each of the sample number of previously exposed shot areas, in response to first layout data for the first exposure frame size, and in accordance with the predetermined sequence;
adjusting of the substrate stage to align the substrate, in response to the results of alignment mark detection; and
positioning of the aligned substrate for exposure of each of the plurality of shot areas of the size which is in accordance with the second exposure frame size, in response to second layout data for the second exposure frame size.

In accordance with the invention there is also provided an exposure method comprising the steps of:
holding, on a substrate stage a substrate having a number of previously exposed shot areas of a size corresponding to a first exposure frame size, each of at least a sample number of the previously exposed shot areas having an alignment mark; and
performing the following exposure sequence;
positioning the substrate, by means of the substrate stage, for alignment mark detection by alignment detection means, for each of the sample number of the previously exposed shot areas, on the basis of first layout data for the first exposure frame size, and detecting the alignment marks thereof;
aligning the substrate (1) by adjusting the substrate stage in response to the results of the alignment mark detection; and
positioning the aligned substrate, by means of the substrate stage, for exposure of each of a plurality of respective shot areas of a size which corresponds to a second exposure frame size greater than the first exposure frame size, on the basis of second layout data for the second exposure frame size, and, at each respective position, exposing each respective shot area of the size which corresponds to the second exposure frame size.

It is acknowledged that European Patent Application EP-A-0150129 describes a technique used for measuring alignment marks for performing alignment and performing exposure for a large frame size. Exposure is performed by rotate-and-repeat operations. The frame used for alignment mark detection, which is the same as that used for exposure, corresponds to one quadrant of the wafer. Each quadrant sector of the wafer has respective pairs of marks. These alignment marks accordingly are defined relative to a frame of the large frame size which has the same size as frames used for wafer exposure. The smaller size circuit elements do not have individual sets of marks which could be used for finer resolution mark detection and substrate and/or shot alignment.

In the accompanying drawings;
Figures 1A and 1B are plan views, respectively, showing examples of different layouts of shots of smaller frame size and of larger frame size, respectively, for detection and exposure in accordance with an embodiment of the present invention;
Figure 2 is a flow chart for explaining the operation wherein layouts such as shown in Figures 1A and 1B are used; and
Figure 3 is a schematic view of a projection exposure apparatus for the manufacture of semiconductor devices, to which the present invention is applied.

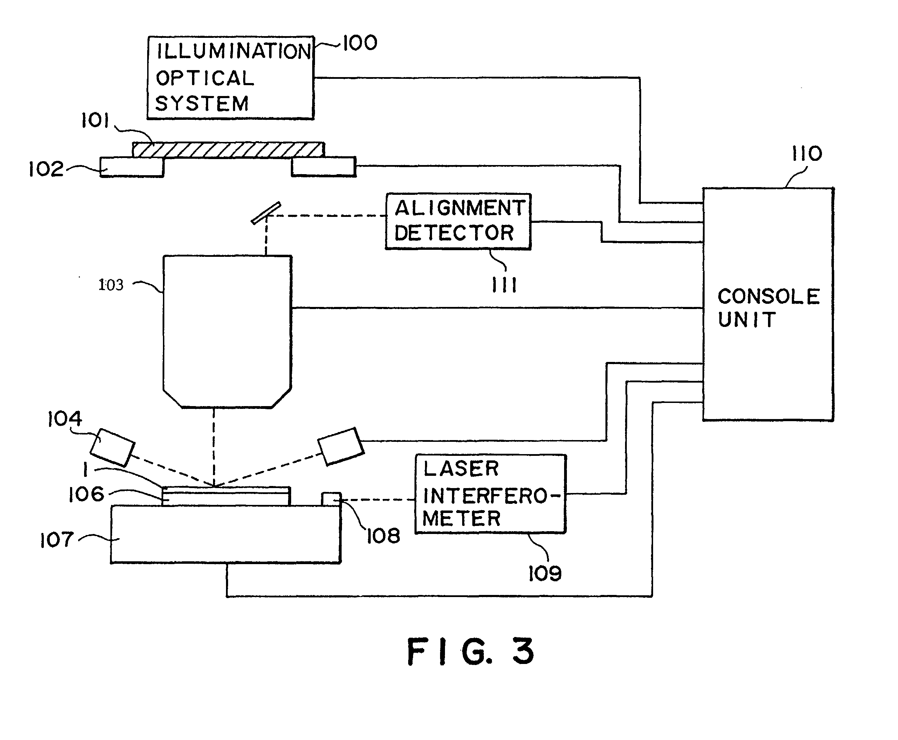

Before describing details of the preferred embodiment of the present invention, a projection exposure apparatus of step-and-repeat type or step-and-scan type, called a stepper, will be explained in conjunction with Figure 3.

In Figure 3, denoted at 100 is an illumination optical system for producing exposure light with which a pattern (having plural chip patterns) formed on a reticle 101 is projected and printed on a photosensitive resist layer, provided on a wafer 1. Denoted at 102 is a reticle stage for holding the reticle 101. In response to projection of exposure light from the illumination optical system 100 upon the reticle 101 held by the reticle stage 102, the pattern of the reticle 101 is projected by a reduction projection lens 103 on the wafer, held by a wafer chuck 106, in a reduced scale.

Denoted at 104 is an autofocus detector of known type. It projects a light beam onto the surface of the wafer 1 and, by detecting reflected light therefrom, it detects the position of the wafer surface in the direction of an optical axis (Z axis direction), with respect to the focusing plane of the projection optical system. On the basis of the result of this detection, the wafer chuck 106 is moved by a driving mechanism (not shown) in the optical axis direction of the projection lens 103, so as to place the wafer 1 surface on the focusing plane of the projection lens 103.

Denoted at 107 is a wafer stage for moving the wafer 1, held by the wafer chuck 106, along a plane (X-Y plane) perpendicular to the optical axis of the projection lens 103. This stage performs step-and-repeat motion for sequential exposures of zones on the wafer 1.

Denoted at 108 is a mirror which is movable integrally with the wafer stage 107 and along the X-Y plane. Denoted at 109 is a known laser interferometer type measuring device for measuring a position along the X-Y plane, and denoted at 110 is a console unit for controlling the projection exposure apparatus as a whole. Denoted at 111 is a known alignment detector for detecting an alignment mark, provided on the wafer 1, through the projection lens 103 to detect the position of the wafer 1 along the X-Y plane. The console unit 110 controls the projection exposure apparatus as a whole, and on the other hand it serves to make determination and selection of shot layout, to be described later. Operational steps to be described below are executed in a CPU of the console unit 110, except mentioned otherwise.

Figures 1A and 1B are plan views showing examples of layout of shots to be exposed by a stepper.

Figure 1A shows an exposure layout to be used in a stepper of large exposure field size in a single exposure (large picture size stepper), and Figure 1B shows an exposure layout to be used in a stepper of small exposure field size in a single exposure (small picture size stepper) or a layout of IC or LSI chips of a number of 112. Denoted in these drawings at 1 is a wafer, and denoted at 2 are shots to be used in the large exposure field size stepper. Denoted at 4 are sample shots for alignment or global leveling, to be used in the large picture size stepper. Denoted at 3 are shots or IC or LSI chips to be used in the small picture size stepper. Denoted at 5 are sample shots for alignment or global leveling, to be used in the small picture size stepper or in the layout of IC or LSI chips.

Figure 1A relates to an example of layout in a large picture size stepper. If in this example the exposure size is 50 mm square and the wafer 1 has a size of 8 inch (1" = 2.54 cm) diameter, then fourteen shots are defined such as shown in Figure 1A. For selection of sample shots for global alignment, global leveling and die-by-die leveling, with this layout there is a possibility that a measured value related to a peripheral shot of the wafer contains an error due to a large variation in film thickness of a photosensitive material on the wafer or to a large distortion of the wafer 1. Excluding such peripheral shots of the wafer from selection of sample shots for this reason, only selectable are four sample shots 4 at the central portion of the wafer 1 as shown in Figure 1A. Since the interval (span) of these four sample shots 4 is very small as compared with the size of the wafer 1, if the global alignment or global leveling is executed on the basis of these sample shots 4 and the placement or tilt of all shots on the wafer 1 is determined, a large error will occur.

Here, considering a layout to be used in a small picture size stepper or a layout of a series of chips such as shown in Figure 1B, even when peripheral shots of a wafer are excluded as described, tens of shots can be selected as the sample shots 5. Also, the span of sample shots defined as a result of this sample shot selection is not very small as compared with the size of the wafer 1. This is effective to reduce an error in the determination of placement or tilt.

In an occasion where a large picture size stepper and a small picture size stepper are used alternately in manufacture of ICs or LSIs, even in the small picture size stepper similar procedures (e.g. global alignment) as in the large picture size stepper are performed. Thus, each shot 3 of the layout for the small picture size stepper shown in Figure 1B is provided with a mark (not shown) to be used for the global alignment operation, for example. Using these marks also in the large picture size stepper substantially makes it possible to select the sample shots 5 in the layout to be used in the small picture size stepper. This can be easily done by setting the same magnification or detecting process to the mark detecting system 111 (Figure 3).

Substantially the same advantageous result is attainable by preparing a separate layout of marks (coordinates of marks on a wafer) for global alignment, for example, in relation to the large picture size stepper. In that occasion, the advantageous result is held even if the stepper is not used alternately with the small picture size stepper.

A layout for a small picture size stepper or a layout of chips such as shown in Figure 1B, or alternatively a layout of mark placement on a wafer prepared separately may be used for the measurement in relation to global alignment, global leveling or die-by-die leveling, for example. The results of measurement may be corrected for the exposure layout of Figure 1A, and the exposure process may be performed by using corrected values and in accordance with the exposure layout. This enables high precision alignment and focus leveling even in a large picture size stepper.

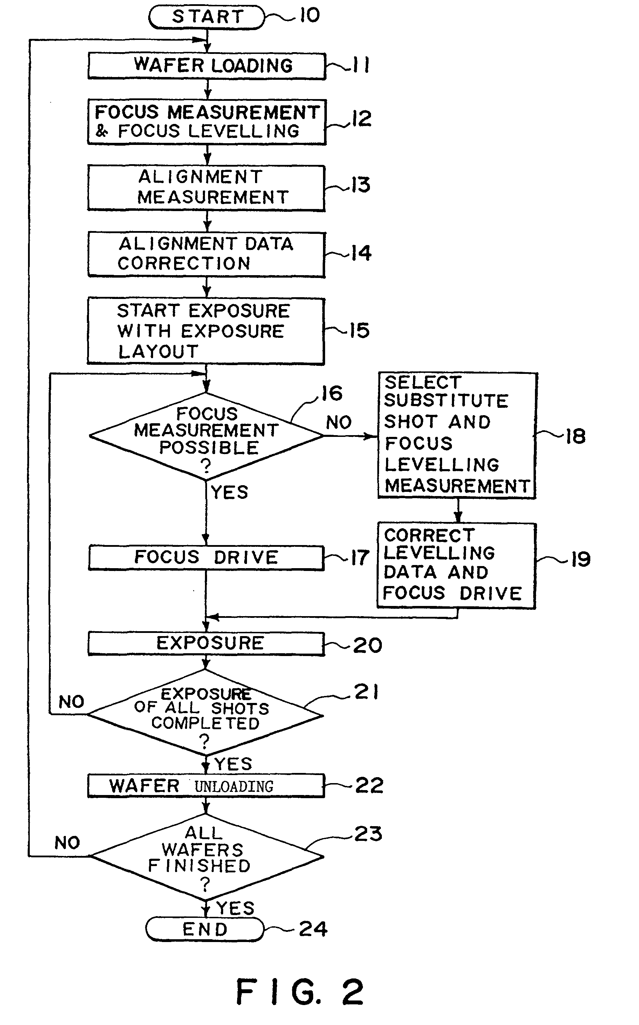

Figure 2 is a flow chart for explaining this procedure. In a stepper, after setting a reticle to be used and setting exposure conditions such as focus, exposure amount and layout preparation, actual exposure sequence starts (Step 10). A wafer is loaded and prealignment of the wafer is performed, and thereafter it is placed on the wafer chuck 106 (Figure 3) of the stepper (Step 11). Then, for measurement of global leveling component of the wafer 1 placed on the chuck 106 and for the leveling of the same, measurement positions (i.e. sample shots 5) are determined in accordance with the focus leveling layout (e.g. shot layout of Figure 1B). On the basis of the determination and by using the autofocus detector 104 (Figure 3), data measurement for the focus leveling is performed. In accordance with the measured data, the leveling is executed (Step 12). Subsequently, for execution of global alignment, measurement positions (sample shots 5) are determined in accordance with the alignment layout (e.g. shot layout of Figure 1B). On the basis of the determination and by using the alignment detection system 111, data measurement for execution of global alignment is performed (Step 13). Then, calculations in relation to the shot interval and the number of shots, for example, are made to transform the measured data into exposure layout (e.g. shot layout of Figure 1A), and the placements of shots in the exposure layout are determined (Step 14). Namely, alignment data is corrected into exposure layout data. Then, exposure process is performed in accordance with the thus determined placements (Step 15).

Subsequently, discrimination is made as to whether data measurement for focus and leveling to a shot to be exposed is possible or not, that is, as to whether that shot is an outside peripheral shot to which measurement is unattainable or not (Step 16). If measurement is possible, drive for focus and leveling is done in accordance with a measured value (Step 17), and exposure of that shot is performed (Step 20). If that shot is one to which measurement is unattainable, the focus leveling layout is referred to and a substitute shot in the focus leveling layout adjacent to that shot is selected. Measurement for focus and leveling is done with respect to the selected substitute shot (Step 18). In accordance with the thus measured data, a value for the focus and leveling to the shot just going to be exposed with the exposure layout, is determined. For example, a focus value may be determined by extrapolation to the leveling data in accordance with tilt of it. The leveling value may be used as it is. On the basis of the thus detected value, drive for focus leveling is done (Step 19). Then, exposure process is performed (Step 20).

The sequential operations at Steps 16 - 20 are repeated with respect to every shot of the wafer. After this is completed, the wafer is unloaded (Step 22). Also, the sequential operations at Steps 11 - 22 are repeated to every wafer, and the procedure is completed (Step 24).

In the flow chart described above, many modifications are possible. As an example, the operations at Steps 11 and 12 may be inserted between Steps 14 and 15. The present invention is not limited to the form depicted in this flow chart.

In the present invention, as described, a separate layout or layouts other than an exposure layout may be prepared as required (for example, an exposure layout, an alignment layout and a focus leveling layout may be prepared). These different layouts may be used in the exposure of a wafer effectively.

In the embodiment of the present invention described above, the alignment layout and the focus levelling layout are the same. However, they may be different from each other.

In general, an alignment operation may be carried out in advance of a step and repeat exposure operation, using a number of sample shot areas, to determine the alignment between the exposure pattern, typically on a reticle, and the surface to be exposed, and the correct relative positions of the exposure pattern and the surface for the exposure shot areas of the step and repeat exposure operation are calculated from the result of the alignment operation even in respect of exposure shot areas which are not used as sample shot areas in the alignment operation. Normally this will involve the use of alignment marks at the sample shot areas on the surface of the exposed, and in some methods alignment marks in the exposure pattern or on the reticle may be used. In a similar manner focusing and levelling operations may be carried out using a plurality of sample shot areas and the results are used for maintaining correct focusing and levelling during the exposure operation even in respect of exposure shot areas which are not used as sample shot areas in the focusing and levelling operations.

In summary it is remarked that an alignment operation at least, is carried out using "nominal" or "theoretical" shot areas, selected from a shot area layout which is not the same as the shot area layout used in the corresponding exposure operation. To put it another way, the "nominal" shot areas are not used as exposure shot areas in the exposure operation. The "nominal" shot areas are smaller than the exposure shot areas. A "nominal" shot area thus may form a part of an exposure shot area, but different "nominal" shot areas are not all at the same position in the respective exposure shot areas. In this way, the spacings between "nominal" shot areas, and the positions thereof, are not constrained to be the same as for the exposure shot areas. Conveniently, where the surface to be exposed is subject to a plurality of exposure operations, e.g. using different exposure patterns, the "nominal" shot areas for one exposure pattern or operation may be the exposure shot areas for a different exposure pattern or operation. Where the surface to be exposed is the surface of a semiconductor wafer on which a plurality of ICs are to be formed, the "nominal" shot areas may for example each be the area of one respective IC in the case that the actual exposure shot areas each cover a plurality of ICs.

The present invention extends to methods of making exposed semiconductor wafers and methods of making integrated circuits using the present exposure method.

## Claims

1. An exposure apparatus comprising:
a substrate stage (106,107) for positioning a substrate (1) having a number of previously exposed shot areas (3), the size of which corresponds to a first exposure frame size, each of at least a sample number (5) of the previously exposed shot areas (3) having an alignment mark;
alignment detection means (111) for detecting the respective alignment marks of the sample number (5) of said previously exposed shot areas (3), in accordance with a predetermined sequence;
exposure means (100-103) for exposing shot areas (2) of the substrate, which shot areas (2) are of a size which corresponds to a second exposure frame size greater than said first exposure frame size; and
control means (110), co-operative with said substrate stage (107), for controlling the positioning of the substrate (1) for alignment detection, for alignment, and for exposure;
**characterised in that**:-
said control means (110) is adapted to control the following operations of an exposure sequence (10-24) for performing the exposure of a plurality of shot areas (2) of the size which is in accordance with said second exposure frame size:
positioning (13) of the substrate (1) for detection of the alignment mark of each of said sample number of previously exposed shot areas (3), in response to first layout data for said first exposure frame size, and in accordance with said predetermined sequence;
adjusting (14) of the substrate stage (106,107) to align the substrate (1), in response to the results of alignment mark detection; and
positioning (15) of the aligned substrate (1) for exposure of each of the plurality of shot areas (2) of the size which is in accordance with said second exposure frame size, in response to second layout data for said second exposure frame size.

2. An apparatus according to claim 1 wherein said control means (110) is adapted to correct the first layout data on the basis of said results of alignment mark detection and to transform the corrected first layout data to generate the second layout data for said second exposure frame size.

3. An apparatus according to either preceding claim including autofocus detection means (104), wherein said control means (110) is adapted to control the following additional operations (12) of said exposure sequence (10-24:
positioning of the substrate (1) for autofocus detection of the level of each of a sample number of the previously exposed shot areas (3) which are of the size that corresponds to the first exposure frame size, in response to focus level detection layout data; and
adjusting of the level of the substrate (1) in response to the results of the autofocus detection of said sample number of the previously exposed shot areas (3).

4. An exposure method comprising steps of:
holding, on a substrate stage (106,107) a substrate (1) having a number of previously exposed shot areas (3) of a size corresponding to a first exposure frame size, each of at least a sample number (5) of the previously exposed shot areas (3) having an alignment mark; and
performing the following exposure sequence (10-24);
positioning said substrate (1), by means of the substrate stage (106,107), for alignment mark detection by alignment detection means (11), for each of said sample number (5) of the previously exposed shot areas (3), on the basis of first layout data for said first exposure frame size, and detecting the alignment marks thereof;
aligning the substrate (1) by adjusting the substrate stage (106,107) in response to the results of the alignment mark detection; and
positioning the aligned substrate (1), by means of the substrate stage (106,107), for exposure of each of a plurality of respective shot areas (2) of a size which corresponds to a second exposure frame size greater than said first exposure frame size, on the basis of second layout data for the second exposure frame size, and, at each respective position, exposing each respective shot area (2) of the size which corresponds to the second exposure frame size.

5. An exposure method according to claim 4 which includes correcting the first layout data on the basis of the results of the alignment mark detection and transforming the corrected first layout data to generate the second layout data for said second exposure frame size.

6. An exposure method according to either of claims 4 or 5 which includes, in the exposure sequence (10-24) for performing the exposure of the shot areas (2) of the size that corresponds to the second exposure frame size:
positioning the substrate (1) for autofocus detection of the level of each of a sample number of the previously exposed shot areas (3), on the basis of focus level detection layout data; and
adjusting the level of the substrate (1) in response to the results of the autofocus detection of the levels of the sample number of the previously exposed shot areas (3).

7. An exposure method according to claim 6 wherein said first layout data for said first exposure frame size is used as said focus level detection layout data.

8. A method of producing an integrated circuit performed by:
providing a substrate (1) having a number of previously exposed shot areas (3) of a size corresponding to a first exposure frame size, each of at least a sample number (5) of the previously exposed shot areas (3) having an adjustment mark, said substrate (1) having a resist coated thereon;
exposing the resist of said resist coated substrate by the method of any of claims 4 to 7; and
completing production of the integrated circuit.

## Patentansprüche

1. Belichtungsvorrichtung mit
einer Substratbühne (106,107) zur Positionierung eines Substrats (1) mit einer Zahl von vorab belichteten Bestrahlungsbereichen (3), deren Größe einer ersten Belichtungsbildgröße entspricht, wobei ein jeder Bestrahlungsbereich von zumindest einer Probenzahl (5) der vorab belichteten Bestrahlungsbereiche (3) eine Ausrichtungsmarkierung aufweist;
einer Ausrichtungserfassungseinrichtung (111) zur Erfassung der jeweiligen Ausrichtungsmarkierungen der Probenzahl (5) der vorab belichteten Bestrahlungsbereiche (3) gemäß einer vorbestimmten Sequenz;
einer Belichtungseinrichtung (100 - 103) zur Belichtung von Bestrahlungsbereichen (2) des Substrats, wobei die Bestrahlungsbereiche eine Größe aufweisen, die einer zweiten Belichtungsbildgröße entspricht, die größer ist als die erste Belichtungsbildgröße; und
einer mit der Substratbühne (107) zusammenwirkenden Steuereinrichtung (110) zur Steuerung der Positionierung des Substrats (1) zur Ausrichtungserfassung, zur Ausrichtung und zur Belichtung;
**dadurch gekennzeichnet, dass**
die Steuereinrichtung (110) zur Steuerung der nachfolgenden Vorgänge einer Belichtungssequenz (10 - 24) zur Ausführung der Belichtung einer Vielzahl von Bestrahlungsbereichen (2) mit einer Größe gemäß der zweiten Belichtungsbildgröße eingerichtet ist:
Positionierung (13) des Substrats (1) zur Erfassung der Ausrichtungsmarkierung eines jeden Bestrahlungsbereichs der Probenzahl der vorab belichteten Bestrahlungsbereiche (3) als Reaktion auf erste Layoutdaten der ersten Belichtungsbildgröße und gemäß der vorbestimmten Sequenz;
Einstellung (14) der Substratbühne (106, 107) zur Ausrichtung des Substrats (1) als Reaktion auf die Ergebnisse der Ausrichtungsmarkierungserfassung; und
Positionierung (15) des ausgerichteten Substrats (1) zur Belichtung eines jeden aus der Vielzahl der Bestrahlungsbereiche (2) mit der Größe gemäß der zweiten Belichtungsbildgröße als Reaktion auf zweite Layoutdaten für die zweite Belichtungsbildgröße.

2. Vorrichtung nach Anspruch 1, wobei die Steuereinrichtung (110) zur Korrektur der ersten Layoutdaten auf der Grundlage der Ergebnisse der Ausrichtungsmarkierungserfassung und zur Wandlung der korrigierten ersten Layoutdaten zur Erzeugung der zweiten Layoutdaten für die zweite Belichtungsbildgröße eingerichtet ist.

3. Vorrichtung nach einem der vorstehenden Ansprüche mit einer Autofokuserfassungseinrichtung (104), wobei die Steuereinrichtung (110) zur Steuerung nachfolgender zusätzlicher Vorgänge (12) der Belichtungssequenz (10 - 24) eingerichtet ist:
Positionierung des Substrats (1) für eine Autofokuserfassung des Niveaus eines jeden Bestrahlungsbereichs (3) aus einer Probezahl der vorab belichteten Bestrahlungsbereiche (3) mit einer Größe gemäß der ersten Belichtungsbildgröße als Reaktion auf Layoutdaten einer Fokussierungs-Nivellierungs-Erfassung; und
Einstellung des Niveaus des Substrats (1) als Reaktion auf die Ergebnisse der Autofokuserfassung der Probenzahl der vorab belichteten Bestrahlungsbereiche (3).

4. Belichtungsverfahren mit den Schritten
Halten eines Substrats (1) mit einer Zahl von vorab belichteten Bestrahlungsbereichen (3) einer Größe gemäß einer ersten Belichtungsbildgröße an einer Substratbühne (106, 107), wobei ein jeder Bestrahlungsbereich von zumindest einer Probenzahl (5) der vorab belichteten Bestrahlungsbereiche (3) eine Ausrichtungsmarkierung aufweist; und
Durchführen der nachfolgenden Belichtungssequenz (10 - 24);
Positionieren des Substrats (1) mittels der Substratbühne (106, 107) für eine Ausrichtungsmarkierungserfassung durch eine Ausrichtungserfassungseinrichtung (11) für einen jeden Bestrahlungsbereich (3) aus der Probenzahl (5) der vorab belichteten Bestrahlungsbereiche (3) auf der Grundlage erster Layoutdaten für die erste Belichtungsbildgröße und Erfassen der Ausrichtungsmarkierungen davon;
Ausrichten des Substrats (1) durch Einstellen der Substratbühne (106, 107) als Reaktion auf die Ergebnisse der Ausrichtungsmarkierungserfassung; und
Positionieren des ausgerichteten Substrats (1) mittels der Substratbühne (106, 107) zur Belichtung eines jeden Bestrahlungsbereiches (2) aus einer Vielzahl jeweiliger Bestrahlungsbereiche (2) einer Größe gemäß einer zweiten Belichtungsbildgröße, die größer als die erste Belichtungsbildgröße ist, auf der Grundlage zweiter Layoutdaten für die zweite Belichtungsbildgröße und Belichten eines jeden jeweiligen Bestrahlungsbereichs (2) der Größe gemäß der zweiten Belichtungsbildgröße an einer jeden jeweiligen Position.

5. Belichtungsverfahren nach Anspruch 4, mit den Schritten zum Korrigieren der ersten Layoutdaten auf der Grundlage der Ergebnisse der Ausrichtungsmarkierungserfassung und zum Wandeln der korrigierten ersten Layoutdaten zum Erzeugen der zweiten Layoutdaten für die zweite Belichtungsbildgröße.

6. Belichtungsverfahren nach Anspruch 4 oder 5, ferner mit den Schritten in der Belichtungssequenz (10 - 24) zum Durchführen der Belichtung der Bestrahlungsbereiche (2) der Größe gemäß der zweiten Belichtungsbildgröße:
Positionieren des Substrats (1) zur Autofokuserfassung des Niveaus eines jeden Bestrahlungsbereichs (3) aus einer Probenzahl der vorab belichteten Bestrahlungsbereiche (3) auf der Grundlage von Layoutdaten einer Fokussierungs-Nivellierungs-Erfassung; und
Einstellen des Niveaus des Substrats (1) als Reaktion auf die Ergebnisse der Autofokuserfassung der Niveaus der Probezahl der vorab belichteten Bestrahlungsbereiche (3).

7. Belichtungsverfahren nach Anspruch 6, wobei die ersten Layoutdaten für die erste Belichtungsbildgröße als die Layoutdaten der Fokussierungs-Nivellierungs-Erfassung verwendet werden.

8. Verfahren zum Herstellen einer integrierten Schaltung mit den Schritten:
Bereitstellen eines Substrats (1) mit einer Zahl von vorab belichteten Bestrahlungsbereichen (3) einer Größe gemäß einer ersten Belichtungsbildgröße, wobei ein jeder Bestrahlungsbereich (3) aus zumindest einer Probezahl (5) der vorab belichteten Bestrahlungsbereiche (3) eine Ausrichtungsmarkierung aufweist und das Substrat (1) eine Abdeckbeschichtung an sich aufweist;
Belichten der Abdeckung des mit der Abdeckung beschichteten Substrats nach einem Verfahren gemäß einem der Ansprüche 4 bis 7; und
Abschließen der Herstellung der integrierten Schaltung.

## Revendications

1. Appareil d'exposition comportant:
une platine (106, 107) pour substrat destinée à positionner un substrat (1) ayant un certain nombre de zones de projection précédemment exposées (3), dont la taille correspond à une première taille de cadre d'exposition, chacune d'au moins un nombre échantillon (5) des zones de projection exposées précédemment (3) ayant un repère d'alignement;
un moyen (111) de détection d'alignement destiné à détecter les repères d'alignement respectifs du nombre échantillon (5) desdites zones de projection précédemment exposées (3), conformément à une séquence prédéterminée;
un moyen d'exposition (100-103) destiné à exposer des zones de projection (2) du substrat, lesquelles zones de projection (2) sont d'une taille qui correspond à une seconde taille de cadre d'exposition supérieure à ladite première taille de cadre d'exposition; et
un moyen de commande (110), coopérant avec ladite platine (107) à substrat, pour commander le positionnement du substrat (1) pour une détection d'alignement, pour un alignement et pour une exposition;
**caractérisé en ce que**:
ledit moyen de commande (110) est conçu pour commander les opérations suivantes sur une séquence d'exposition (10-24) afin d'effectuer l'exposition d'une pluralité de zones de projection (2) de la taille qui est conforme à ladite seconde taille de cadre d'exposition:
le positionnement (13) du substrat (1) pour la détection du repère d'alignement de chacune dudit nombre échantillon de zones de projection précédemment exposées (3), en réponse à des premières données d'agencement pour ladite première taille de cadre d'exposition, et conformément à ladite séquence prédéterminée;
le réglage (14) de la platine (106, 107) à substrat pour aligner le substrat (1), en réponse aux résultats de la détection de repère d'alignement; et
le positionnement (15) du substrat aligné (1) pour l'exposition de chacune de la pluralité de zones de projection (2) de la taille qui est conforme à ladite seconde taille de cadre d'exposition, en réponse à des secondes données d'agencement pour ladite seconde taille de cadre d'exposition.

2. Appareil selon la revendication 1, dans lequel ledit moyen de commande (110) est conçu pour corriger lesdites premières données d'agencement sur la base desdits résultats de détection de repère d'alignement et pour transformer les premières données d'agencement corrigées afin de générer les secondes données d'agencement pour ladite seconde taille de cadre d'exposition.

3. Appareil selon l'une des revendications précédentes, comprenant un moyen (104) de détection de mise au point automatique, dans lequel ledit moyen de commande (110) est conçu pour commander les opérations additionnelles suivantes (12) de ladite séquence d'exposition (10-24) :
le positionnement du substrat (1) pour une détection de mise au point automatique du niveau de chacune d'un nombre échantillon des zones de projection précédemment exposées (3) qui sont de la taille qui correspond à la première taille de cadre d'exposition, en réponse à des données d'agencement de détection de niveau au point; et
le réglage du niveau du substrat (1) en réponse aux résultats de la détection de mise au point dudit nombre échantillon des zones de projection précédemment exposées (3).

4. Procédé d'exposition comprenant les étapes qui consistent:
à maintenir, sur une platine (106, 107) à substrat, un substrat (1) ayant un certain nombre de zones de projection précédemment exposées (3) d'une taille correspondant à une première taille de cadre d'exposition, chacune d'au moins un nombre échantillon (5) des zones de projection précédemment exposées (3) ayant un repère d'alignement ; et
l'exécution de la séquence d'exposition suivante (10-24);
le positionnement dudit substrat (1), au moyen de la platine (106, 107) à substrat, pour une détection de repère d'alignement par un moyen (11) de détection d'alignement, pour chacune dudit nombre échantillon (5) des zones de projection précédemment exposées (3), sur la base de premières données d'agencement pour ladite première taille de cadre d'exposition, et la détection de ses repères d'alignement;
l'alignement du substrat (1) par réglage de la platine (106, 107) à substrat en réponse aux résultats de la détection de repères d'alignement; et
le positionnement du substrat aligné (1), au moyen de la platine (106, 107) à substrat, pour une exposition de chacune d'une pluralité de zones de projection respectives (2) d'une taille qui correspond à une seconde taille de cadre d'exposition plus grande que ladite première taille de cadre d'exposition, sur la base de secondes données d'agencement pour la seconde taille de cadre d'exposition, et, à chaque position respective, l'exposition de chaque zone de projection respective (2) de la taille qui correspond à la seconde taille de cadre d'exposition.

5. Procédé d'exposition selon la revendication 4, qui comprend la correction des premières données d'agencement sur la base des résultats de la détection de repères d'alignement et la transformation des premières données d'agencement corrigées pour générer les secondes données d'agencement pour la dite seconde taille de cadre d'exposition.

6. Procédé d'exposition selon l'une des revendications 4 ou 5, qui comprend, dans la séquence d'exposition (10-24) pour l'exécution de l'exposition des zones de projection (2) de la taille qui correspond à la seconde taille de cadre d'exposition:
le positionnement du substrat (1) pour une détection de mise au point automatique du niveau de chacune d'un nombre échantillon des zones de projection précédemment exposées (3), sur la base de données d'agencement pour la détection du niveau de mise au point; et
le réglage du niveau du substrat (1) en réponse aux résultats de la détection de mise au point automatique des niveaux du nombre échantillon des zones de projection précédemment exposées (3).

7. Procédé d'exposition selon la revendication 6, dans lequel lesdites premières données d'agencement pour ladite première taille de cadre d'exposition sont utilisées en tant que lesdites données d'agencement pour la détection du niveau de mise au point.

8. Procédé de production d'un circuit intégré exécuté par:
l'utilisation d'un substrat (1) ayant un certain nombre de zones de projection précédemment exposées (3) d'une taille correspondant à une première taille de cadre d'exposition, chacune d'au moins un nombre échantillon (5) des zones de projection précédemment exposées (3) ayant un repère d'alignement, ledit substrat (1) portant un revêtement de résist;
l'exposition du résist dudit substrat revêtu de résist par le procédé selon l'une quelconque des revendications 4 à 7; et
l'achèvement de la production du circuit intégré.
